# EUROPÄISCHE PATENTSCHRIFT

(11) **EP 3 400 452 B1**
(45) Veröffentlichungstag und Bekanntmachung des Hinweises auf die Patenterteilung: **13.07.2022**
(21) Anmeldenummer: 17705816.1
(22) Anmeldetag: 08.02.2017
(51) Int. Cl.: G01R 31/00

(54) **TRANSPORTEINHEIT MIT ZUMINDEST EINER ANLAGE**
TRANSPORT UNIT HAVING AT LEAST ONE INSTALLATION
UNITÉ DE TRANSPORT COMPRENANT AU MOINS UNE INSTALLATION

(30) Priorität: 07.03.2016 DE 102016203676
(43) Veröffentlichungstag der Anmeldung: 14.11.2018
(73) Patentinhaber: Siemens Mobility GmbH, 81739 München (DE)
(72) Erfinder: DAHMS, Frank, 91315 Höchstadt/Aisch (DE); DIRAUF, Michael, 96231 Bad Staffelstein (DE)
(86) Internationale Anmeldenummer: PCT/EP2017/052674
(87) Internationale Veröffentlichungsnummer: WO 2017/153111

(56) Entgegenhaltungen:
- DE-A1-102014 201 729
- DE-A1-102014 214 225
- US-A- 5 214 582
- US-A1- 2015 276 555

## Beschreibung

Die Erfindung betrifft eine Transporteinheit mit zumindest einer Anlage.

In technischen Anlagen an Bord von Transporteinheiten, insbesondere Schienenfahrzeugen, kommt es im Betrieb zu Ausfällen von Bauteilen. Zu diesen ist eine schnelle und möglichst genaue Fehlerlokalisierung erforderlich, um den Fehler zu beheben und die Stillstandzeiten der Anlage zu minimieren.

US 2015/0276555 A1 beschreibt eine Zugtestplattform zum Testen der Integration einer Zugkomponente in einen Zug, welcher mehrere Wagen aufweist.

DE 10 2014 214 225 A1 beschreibt ein Schienenfahrzeug mit mehreren Betriebsmittelsubsystemen, die einen Betrieb des Schienenfahrzeugs ermöglichen. Die Betriebsmittelsubsysteme sind mittels eines Datenkommunikationssystems kommunikationstechnisch miteinander verbunden. Das Datenkommunikationssystem weist eine Verwaltungseinheit auf, die dazu vorgesehen ist, eine Datenkommunikation zu verwalten. In einem Simulationsmodus der Verwaltungseinheit kann eine Simulation im jeweiligen Subsystem durchgeführt werden. Die Verwaltungseinheit ist dabei in der Lage, das jeweilige Subsystem in dessen Simulationsmodus zu versetzen. Die in einem Überwachungsmodus und dem Simulationsmodus von I/O-Modulen erfassten Signale werden an die Verwaltungseinheit übermittelt, welche diese Signale zur Auswertung weiter verarbeitet.

Der Erfindung liegt die Aufgabe zugrunde, eine Transporteinheit bereitzustellen, bei welcher eine schnelle und genaue Fehlerlokalisierung erreicht werden kann.

Hierzu wird eine Transporteinheit gemäss dem Anspruch 1 vorgeschlagen. Durch die Anordnung einer derartigen Simulationseinrichtung an Bord der Transporteinheit können aktuelle Zustandsdaten über kurze Übertragungswege schnell an die Simulationseinrichtung übertragen werden. Im Gegensatz zu einer Diagnosemethode, die auf einem Vergleich eines Ist-Zustands der Anlage mit einem statischen Modell der Anlage basiert, werden Zustände zumindest des Teils der Anlage vorteilhafterweise dynamisch simuliert. Darunter soll insbesondere verstanden werden, dass die Simulationseinrichtung dynamische Prozesse, wie insbesondere die Betätigung von Bauteilen, z.B. das Betätigen eines Schalters, das Ein- oder Ausschalten eines elektrischen Verbrauchers usw. simuliert. Dabei werden simulierte Zustandsdaten erzeugt, die für einen Zustand wenigstens des Teils der Anlage als Ergebnis eines dynamischen Prozesses repräsentativ sind. In diesem Sinne kann die Simulationseinrichtung dadurch charakterisiert werden, dass deren Recheneinheit zum dynamischen Ermitteln simulierter Zustandsdaten vorgesehen ist.

Die aktuellen Zustandsdaten sind vorzugsweise für einen aktuellen Zustand wenigstens eines Teils der Anlage repräsentativ. Dabei kann es sich zumindest teilweise um den gleichen Teil der Anlage, für dessen Zustand die simulierten Zustandsdaten repräsentativ sind, oder um einen unterschiedlichen Teil handeln, wobei zwischen beiden Teilen vorzugsweise ein funktionaler Zusammenhang besteht.

Die Transporteinheit weist vorzugsweise Sensoreinheiten auf, die jeweils zur Erfassung zumindest einer Zustandskenngröße der Anlage vorgesehen sind, wobei die aktuellen Zustandsdaten auf der Basis von Zustandskenngrößen bereitgestellt werden. Die Zustandskenngrößen können zur Bereitstellung aktueller Zustandsdaten über ein Steuerungsnetzwerk der Transporteinheit übertragen werden, wobei die Sensoreinheiten dabei vorzugsweise mit zumindest einer Schnittstelleneinheit in Verbindung stehen, die an das Steuerungsnetzwerk angeschlossen ist. Dabei kann die Schnittstelleinheit als sogenannte Input-Output-Schnittstelle (auch "I/O-Baustein" genannt) ausgeführt sein. Beispiele für Zustandskenngrößen sind eine Temperaturkenngröße, eine Statuskenngröße, die z.B. für die Zustände "ein/aus", "offen/geschlossen" repräsentativ ist, eine Spannungs- oder Stromkenngröße usw. In diesem Zusammenhang kann eine Überwachungseinheit, die zur Überwachung des Zustands einer ihr zugeordneten Einheit vorgesehen ist, als Sensoreinheit verstanden werden. Unter einer Zustandskenngröße "der Anlage" soll eine Kenngröße für den Zustand von zumindest einer Komponente der Anlage verstanden werden.

Zustandskenngrößen können außerdem durch Subsysteme der Anlage über subsystemeigene Schnittstellen ausgegeben werden. Insbesondere sind die Subsysteme jeweils über eine solche eigene Schnittstelle an das oben beschriebene Steuerungsnetzwerk angeschlossen. Beispiele für Subsysteme in einer Transporteinheit sind ein Türsteuerungssystem, ein Bremssteuerungssystem, ein Antriebssteuerungssystem, ein Beleuchtungssteuerungssystem usw. Zustandskenngrößen eines Subsystems können eine von einer Sensoreinheit des Subsystems erfasste Kenngröße, eine von einer Steuereinheit des Subsystems ausgegebene Statusmeldung usw. sein.

Die aktuellen Zustandsdaten können Zustandskenngrößen entsprechen oder sie können auf der Basis von Zustandskenngrößen erzeugt werden.

Die Simulationsdaten sind sinnvollerweise anhand von Informationen gebildet, die für die Anlage, insbesondere deren Struktur, deren Funktionen und die funktionalen Zusammenhänge zwischen deren Komponenten spezifisch sind. Besonders vorteilhaft können für die Simulationseinrichtung, die im normalen Betrieb der Transporteinheit simulierte Zustandsdaten ermittelt, Simulationsdaten benutzt werden, die bei der Entwicklung und/oder bei Testvorgängen der Transporteinheit erzeugt werden. Die aufwendige Erzeugung eines statischen, für die Transporteinheit äußerst spezifischen Modells kann vermieden werden.

In einer vorteilhaften Ausführung der Erfindung basieren die Simulationsdaten auf der zumindest teilautomatisierten, vorteilhaft vollautomatisierten Umwandlung von Stromlaufplandaten der Anlage. Die Simulationsdaten können besonders vorteilhaft zumindest teilautomatisiert durch eine entsprechende Software auf der Basis von Schaltplänen der Anlage generiert werden. Dies erfolgt typischerweise während der Entwicklung und/oder der Testphase einer Transporteinheit, wobei die Ergebnisse dieser Herstellphasen der Transporteinheit vorteilhaft für die Ausführung von Simulationen an Bord der Transporteinheit während deren normalen Betriebs benutzt werden können.

Erfindungsgemäß weist die Simulationseinrichtung eine Speichereinheit auf, in welcher zumindest ein von der Recheneinheit ausführbares Simulationsprogramm gespeichert ist, wobei die Simulationsdaten als Bestandteil des Simulationsprogramms bereitgestellt sind. Hierdurch kann eine besonders schnelle Erzeugung von simulierten Zustandsdaten anhand der Simulationsdaten erfolgen, da Zugriffe der Recheneinheit auf außerhalb des Simulationsprogramms gespeicherte Simulationsdaten vermindert, insbesondere vermieden werden können. Die Simulationsdaten werden vorzugweise bei einem Kompilieren des Simulationsprogramms in dieses eingebunden. Unter einem 'Kompilieren' soll insbesondere die Erzeugung einer von der Recheneinheit ausführbaren Programmdatei verstanden werden. Beispielsweise kann diese Datei den typischen ".exe" Format aufweisen.

In einer vorteilhaften Ausführung der Erfindung wird vorgeschlagen, dass die Transporteinheit eine Dateneinrichtung aufweist, die dazu vorgesehen ist, die aktuellen Zustandsdaten zur Verfügung zu stellen, und mit welcher die Simulationseinrichtung über die Schnittstelle datentechnisch verbindbar ist. Hierdurch kann eine in der Transporteinheit zentrale Bereitstellung aktueller Zustandsdaten erreicht werden, wodurch eine einfache Übertragung der Zustandsdaten für die Simulationseinrichtung erzielt werden kann.

In diesem Zusammenhang wird vorgeschlagen, dass die Transporteinheit eine Steuereinheit zum Steuern der Anlage aufweist, wobei die Dateneinrichtung zumindest teilweise Bestandteil der Steuereinheit ist. Hierdurch kann eine in der Anlage, typischerweise mit einer in der Anlage zentralen Funktionalität versehene Einheit als Dateneinrichtung benutzt werden. Dabei kann die Bereitstellung aktueller Zustandsdaten dadurch erfolgen, dass die Steuereinheit ein Prozessabbild der Anlage für eine Datenübertragung an die Simulationseinrichtung zur Verfügung stellt. Ein derartiges Prozessabbild besteht beispielsweise bei speicherprogrammierbaren Steuerungen (oder "SPS").

Eine Auswertung simulierter Zustandsdaten kann vorteilhaft zu Diagnosezwecken erfolgen, indem die Transporteinheit eine Diagnoseeinrichtung mit einer ersten Schnittstelle, über welche aktuelle Zustandsdaten der Anlage empfangbar sind, einer zweiten Schnittstelle, über welche die simulierten Zustandsdaten empfangbar sind, und einer Auswerteeinheit aufweist, die dazu vorgesehen ist, die aktuellen Zustandsdaten mit den simulierten Zustandsdaten zu vergleichen.

Eine besonders vorteilhafte, im normalen Betrieb der Transporteinheit erfolgende Erzeugung von Fehlermeldungen und ein sicherer Betrieb der Anlage können erreicht werden, wenn die simulierten Zustandsdaten für einen Sollzustand des Teils der Anlage repräsentativ sind und die Diagnoseeinrichtung dazu vorgesehen ist, eine Fehlermeldung zu erzeugen, wenn eine Abweichung vom Sollzustand durch die Auswerteeinheit erkannt wird.

In diesem Zusammenhang wird vorgeschlagen, dass die Diagnoseeinrichtung dazu vorgesehen ist, zur Erzeugung einer Fehlermeldung bezüglich einer ersten Einheit der Anlage Strukturdaten zu berücksichtigen, welche für topologische und/oder funktionelle Zusammenhänge der Einheit mit zumindest einer zweiten Einheit der Anlage repräsentativ sind. Hierdurch kann die Erzeugung von Fehlermeldungen bestimmten Regeln unterliegen, wobei die Regelanwendung auf der Basis der Strukturdaten erfolgt. Beispielsweise können auf die erste Einheit der Anlage bezogene Strukturdaten für eine relative Anordnung dieser Einheit zu einer als Spannungsquelle ausgebildeten zweiten Einheit repräsentativ sein. Die Strukturdaten können alternativ oder zusätzlich für die topologische, insbesondere schaltungstechnische Struktur repräsentativ sein, in welcher die erste Einheit und die zweite Einheit angeordnet sind. Insbesondere können die Strukturdaten die Zugehörigkeit der ersten Einheit und der zweiten Einheit zu einem gleichen Zweig oder einem unterschiedlichen Zweig relativ zu einer noch weiteren, als Spannungsquelle ausgebildeten Einheit repräsentieren. Dabei kann vorteilhafterweise anhand der Strukturdaten bestimmt werden, ob die erste Einheit und die zweite Einheit relativ zur Spannungsquelle parallel oder in Reihe zueinander geschaltet sind.

Insbesondere kann durch eine auf Strukturdaten gestützte regelbasierte Erzeugung von Fehlermeldungen eine Anzahl erzeugter Fehlermeldungen sinnvollerweise beschränkt werden, indem die Diagnoseeinrichtung dazu vorgesehen ist, beim Erkennen eines Satzes von Fehlern eine Fehlermeldung zumindest einem ersten Fehler zuzuordnen und anhand der Strukturdaten die Erzeugung von Meldungen zu Fehlern zu unterdrücken, die ein Kausalitätsverhältnis zum ersten Fehler aufweisen. Hierdurch kann insbesondere eine unerwünschte Kaskade von Fehlermeldungen aufgrund von Fehlern vermieden werden, die aus dem ersten Fehler folgen. Dies ist beispielsweise für einen Satz von Fehlern von Vorteil, welche zu Einheiten erkannt werden, die bezüglich einer Spannungsquelle in Reihe zueinander angeordnet sind.

In einer bevorzugten Ausbildung der Erfindung sind die Strukturdaten und die Simulationsdaten auf der Basis zumindest eines gemeinsamen Datensatzes, insbesondere eines Satzes von Stromlaufplandaten bereitgestellt.

Besonders vorteilhaft ist die Diagnoseeinrichtung über die erste Schnittstelle mit der oben beschriebenen Dateneinrichtung datentechnisch verbindbar.

Die Transporteinheit kann für den Gütertransport vorgesehen sein. Alternativ oder zusätzlich kann sie für den Transport von Personen vorgesehen sein. Die Transporteinheit ist vorzugsweise als Transportmittel für den öffentlichen Transport von Passagieren ausgebildet. Der Betrieb von öffentlichen Transportmitteln, und besonders von Schienenfahrzeugen, unterliegt heutzutage immer strengeren Anforderungen bezüglich des Personenschutzes (auch "Safety"-Anforderungen genannt). Die Transporteinheit kann als Fahrzeug, Flugzeug oder Schiff ausgebildet sein. Vorzugsweise ist sie als Schienenfahrzeug ausgebildet. Der Betrieb von Schienenfahrzeugen unterliegt immer strengeren Anforderungen bezüglich einer Früherkennung von Defekten zur Erhöhung der Wartungseffizienz.

Durch die Erfindung kann eine schnelle und zuverlässige Fehlererkennung erfolgen. Dem liegt die Annahme zugrunde, dass ein simulierter Betrieb der Anlage fehlerfrei verläuft. Insbesondere können simulierte Zustandsdaten schnell eine besonders zuverlässige Vergleichsbasis zur Fehlererkennung bilden.

Die Erfindung betrifft außerdem ein Verfahren gemäss dem Anspruch 14 zum Steuern einer Anlage bei einer Transporteinheit, insbesondere einem Schienenfahrzeug.

Es wird vorgeschlagen, dass während eines Betriebs der Transporteinheit aktuelle Zustandsdaten der Anlage bereitgestellt werden, die aktuellen Zustandsdaten von einer Simulationseinrichtung der Transporteinheit empfangen werden und die Simulationseinrichtung auf der Basis der aktuellen Zustandsdaten und von Simulationsdaten simulierte Zustandsdaten ermittelt, die für einen Zustand wenigstens eines Teils der Anlage repräsentativ sind. Zu den vorteilhaften Wirkungen des vorgeschlagenen Verfahrens wird auf die obigen Ausführungen zur erfindungsgemäßen Transporteinheit verwiesen.

Ist die Transporteinheit als Transportmittel für den öffentlichen Transport von Passagieren ausgebildet, wird das Verfahren vorteilhafterweise während eines Fahrgastbetriebs der Transporteinheit ausgeführt.

Es wird ein Ausführungsbeispiel der Erfindung anhand der Zeichnungen erläutert. Es zeigen:
- Figur 1:: ein Schienenfahrzeug mit einer Anlage in einer schematischen Seitenansicht,
- Figur 2:: eine Simulationseinrichtung und eine Diagnoseeinrichtung des Schienenfahrzeugs aus Figur 1 und
- Figur 3:: einen Teil der Anlage in einer realen Darstellung und einer simulierten Darstellung.

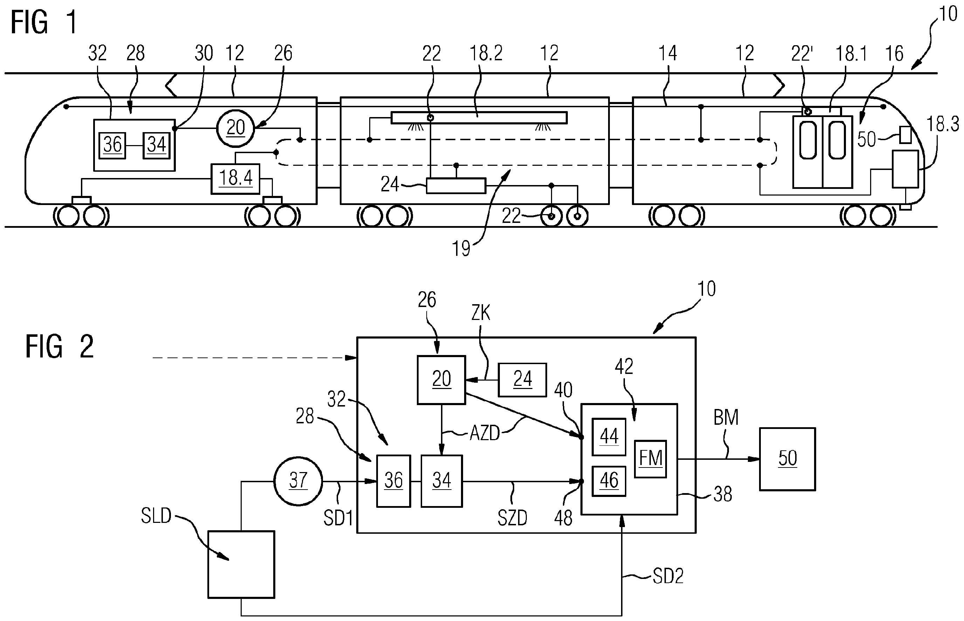

Figur 1 zeigt ein als Schienenfahrzeug 10 ausgebildete Transporteinheit in einer schematischen Seitenansicht. Das Schienenfahrzeug 10 ist als Verband von Wagen 12 ausgebildet, die für den Transport von Passagieren dienen. Die Wagen 12 können als Triebwagen, welcher zumindest eine Antriebseinheit zum Antreiben wenigstens einer Triebachse (nicht gezeigt) oder als antriebslose Wagen ausgebildet sein. Das Schienenfahrzeug 10 bildet in der betrachteten Ausführung einen sogenannten Triebzug mit zumindest einem Triebwagen und entspricht einer im normalen Fahrgastbetrieb untrennbaren Einheit. Alternativ kann das Schienenfahrzeug einem Teil eines solchen Triebzuges entsprechen. Dabei und bezüglich eines Zugnetzwerks 14 - z.B. das sogenannte "TCN" oder "Train Communication Network" (IEC 61375) - kann das Schienenfahrzeug 10 ein in diesem Netzwerk definiertes "Consist" bilden. In einer weiteren, nicht gezeigten Alternative kann das Schienenfahrzeug 10 von einem einzelnen Wagen - Triebwagen oder antriebsloser Wagen - gebildet sein.

Das Schienenfahrzeug 10 weist eine Anlage 16 auf, welche von Funktionseinheiten 18.1, 18.2, 18.3, 18.4 gebildet ist. Typische Funktionseinheiten eines Schienenfahrzeugs sind dabei eine Türsteuereinrichtung (Funktionseinheit 18.1), eine Beleuchtungseinrichtung (Funktionseinheit 18.2), eine Zugsicherungseinrichtung (Funktionseinheit 18.3), eine Bremssteuereinrichtung (Funktionseinheit 18.4). Es sind weitere Funktionseinheiten im Schienenfahrzeug 10 vorhanden, die der Übersichtlichkeit halber nicht dargestellt sind. Die Funktionseinheiten 18 können auch in der fachmännischen Sprache "Subsysteme" genannt werden.

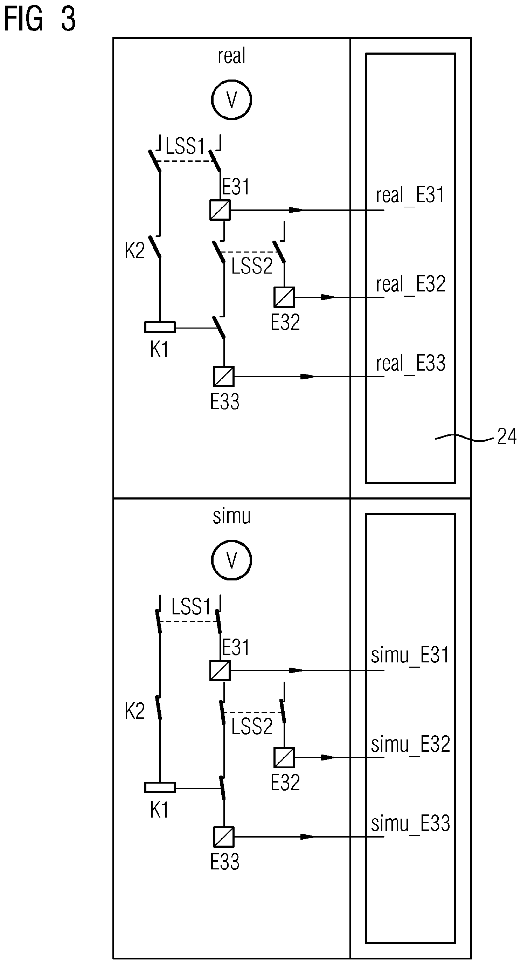

Die Anlage 16 umfasst des Weiteren Mittel zur Versorgung elektrischer Verbraucher der Funktionseinheiten 18, wobei diese Mittel als Elemente zur Führung einer elektrischen Spannung oder betätigbare Elemente, z.B. Schalter, zur Herstellung bzw. zur Unterbrechung einer elektrischen Verbindung ausgebildet sind. Beispiele dafür sind in Figur 3 gezeigt. Die Transporteinheit 16 weist zudem zumindest ein gestrichelt dargestelltes Steuerungsnetzwerk 19 auf, an welches die Funktionseinheiten 18 und eine Steuereinheit 20 zur Steuerung eines Betriebs der Anlage 16 angeschlossen sind. Das Steuerungsnetzwerk 19 kann z.B. als Profinet^{®}-Ring ausgebildet sein.

Das Steuerungsnetzwerk 19 ist außerdem mit dem Zugnetzwerk 14 verbunden. Dieses ermöglicht eine Datenkommunikation mit weiteren, mit dem Schienenfahrzeug 10 gekoppelten Schienenfahrzeugen (nicht gezeigt). Das Zugnetzwerk 14 kann wie oben geschrieben gemäß der Norm IEC 61375 als ETB (oder Ethernet Train Backbone) ausgebildet sein.

Das Schienenfahrzeug 10 umfasst außerdem Sensoreinheiten 22, die zur Erfassung von Zustandskenngrößen der Anlage 16 vorgesehen sind. Die Sensoreinheiten 22 sind insbesondere - über eine Schnittstelleneinheit 24, z.B. in der Form eines I/O-Moduls ausgebildet - an das Steuerungsnetzwerk 20 angeschlossen. Diese Schnittstelleneinheit 24 - auch Modul der sogenannten "dezentralen Peripherie" genannt - ist als Station ausgebildet, über welche durch die in einem Teil der Anlage 16 angeordneten Sensoreinheiten 22 erfasste Zustandskenngrößen eingelesen und an die zentrale Steuereinheit 20 übermittelt werden können. Es sind ferner Sensoreinheiten 22' vorhanden, die Bestandteile einer bestimmten Funktionseinheit 18 bzw. eines bestimmten Subsystems - wie in der Figur gezeigt z.B. eines Türsteuerungssystems - sind. Dieses Subsystem weist eine eigene Schnittstelle auf, über welche es datentechnisch an das Steuerungsnetzwerk 19 angeschlossen ist. Eine von einer Sensoreinheit 22' in einem Subsystem erfasste Zustandskenngröße wird über diese subsystemeigene Schnittstelle an die Steuereinheit 20 über das Steuerungsnetzwerk 19 übertragen.

Die Steuereinheit 20 stellt auf der Basis der Zustandskenngrößen Zustandsdaten der Anlage 16 zur Verfügung und weist dabei in dieser Hinsicht die Funktion einer Dateneinrichtung 26 auf. Die Steuereinheit 20 kann als SPS ausgebildet sein und die Zustandsdaten durch eine Zurverfügungstellung eines sogenannten Prozessabbildes der Anlage 16 bereitstellen.

Das Schienenfahrzeug 10 weist außerdem eine Simulationseinrichtung 28 auf, deren Aufbau und Funktionsweise nun erläutert werden.

Die Simulationseinrichtung 28 steht datentechnisch mit der Steuereinheit 20 in Verbindung. Dies erfolgt über eine Schnittstelle 30, welche als physikalische Anschlusseinheit oder als logischer Port ausgebildet ist. Die Simulationseinrichtung 28 umfasst des Weiteren eine Recheneinheit 32, die zumindest eine Prozessoreinheit 34, mittels derer zumindest ein Simulationsprogramm ausführbar ist, und eine Speichereinheit 36 aufweist, in welcher zumindest das Programm gespeichert ist.

Die Funktionsweise wird anhand der Figur 2 näher erläutert. Diese zeigt das Schienenfahrzeug 10 in einer stark schematischen Ansicht.

Die mit dem Simulationsprogramm ausgestattete Recheneinheit 32 ist dazu vorgesehen, auf der Basis von Simulationsdaten SD1 und aktuellen Zustandsdaten AZD simulierte Zustandsdaten SZD zu ermitteln, die für einen Zustand wenigstens eines Teils der Anlage 16 repräsentativ sind. Die aktuellen Zustandsdaten AZD werden wie oben beschrieben von der Steuereinheit 20 in ihrer Funktion als Dateneinrichtung 26 zur Verfügung gestellt. Sie werden auf der Basis von der Steuereinheit 20 eingelesener Zustandskenngrößen ZK zur Verfügung gestellt und sind für einen aktuellen Zustand des entsprechenden Teils der Anlage 16 repräsentativ, der z.B. einer bestimmten Schnittstelleneinheit 24 zugeordnet ist. Die aktuellen Zustandsdaten AZD werden von der Simulationseinrichtung 28 über deren Schnittstelle 30 empfangen (siehe Figur 1).

Die Ermittlung simulierter Zustandsdaten SZD durch die Recheneinheit 32 erfolgt auf der Basis von Simulationsdaten SD1, welche für den Teil der Anlage 16, zu welchem die aktuellen Zustandsdaten AZD empfangen werden, einen anderen Teil der Anlage 16 und/oder die komplette Anlage 16 repräsentativ sind. Sie sind insbesondere für konstruktive Merkmale des Teils und für Verhältnisse, insbesondere Abhängigkeiten zwischen Komponenten dieses Teils charakteristisch.

Die Simulationsdaten SD1 basieren auf der zumindest teilautomatisierten Umwandlung von Stromlaufplandaten SLD der Anlage 16. Beispielsweise sind diese Stromlaufplandaten SLD für Leitungswege elektrischer Signale innerhalb der Anlage 16 repräsentativ. Die Erzeugung der Simulationsdaten SD1 kann während des Betriebs des Schienenfahrzeugs 10 im Schienenfahrzeug 10 und/oder in einer landseitigen Einrichtung erfolgen. Bevorzugt ist jedoch, dass die Simulationsdaten SD1 während einer Entwicklungsphase des Schienenfahrzeugs 10 generiert und in einer Speichereinheit, insbesondere der Speichereinheit 36 gespeichert werden. Hierzu können Simulationsdaten herangezogen werden, die ohnehin während einer Testphase einer Steuerungssoftware zur Steuerung eines Betriebs der Anlage 16 erzeugt werden.

Die Simulationsdaten SD1 sind zumindest teilweise im Simulationsprogramm enthalten, indem die Simulationsdaten SD1 bei dessen Kompilieren - d.h. Erzeugen einer von der Prozessoreinheit 34 ausführbaren Datei - einbezogen werden. Das von der Prozessoreinheit 34 ausführbare Simulationsprogramm wird bei der Entwicklung oder einer Testphase des Schienenfahrzeugs 10 auf der Basis der Stromlaufplandaten SLD mittels eines Compilers 37 kompiliert und enthält daher die Simulationsdaten SD1.

Alternativ oder zusätzlich können die Simulationsdaten SD1 vom Simulationsprogramm während der Programmdurchführung aus der Speichereinheit 36 geholt werden.

Die Simulationsdaten SD1 legen einer virtuellen Darstellung zumindest des entsprechenden Teils der Anlage 16 zugrunde. Die Recheneinheit 32 kann bei der Ausführung des Simulationsprogramms dynamische Änderungen in dieser virtuellen Darstellung bewirken, indem z.B. ein Schalter der Anlage 16 in der virtuellen Darstellung betätigt wird. Solche virtuelle Betätigungsvorgänge erfolgen insbesondere auf der Grundlage der aktuellen Zustandsdaten AZD. Ist eine erfasste Zustandskenngröße ZK für die Tatsache repräsentativ, dass eine bestimmte Leitung Spannung führend ist, wird z.B. in der aus den Simulationsdaten SD1 hervorgehenden virtuellen Darstellung des entsprechenden Teils der Anlage 16 ein Schalter betätigt, welcher von dieser Spannung erreicht wird. Dieser bewirkt ggf. eine Änderung im virtuellen Zustand des betrachteten Teils der Anlage 16, wobei die ermittelten simulierten Zustandsdaten SZD für diesen virtuellen Zustand repräsentativ sind.

Das Schienenfahrzeug 10 weist ferner eine Diagnoseeinrichtung 38 auf, deren Aufbau und Funktionsweise nun beschrieben werden.

Die Diagnoseeinrichtung 38 steht datentechnisch mit der Steuereinheit 20 in ihrer Funktion als Dateneinrichtung 26 in Verbindung. Dies erfolgt über eine erste Schnittstelle 40, welche als physikalische Anschlusseinheit oder als logischer Port ausgebildet ist. Die Diagnoseeinrichtung 38 umfasst des Weiteren eine Auswerteeinheit 42, die zumindest eine Prozessoreinheit 44, mittels derer zumindest ein Diagnoseprogramm ausführbar sind, und eine Speichereinheit 46 aufweist, in welcher zumindest das Programm gespeichert ist. Die Diagnoseeinrichtung 38 weist außerdem eine zweite Schnittstelle 48 auf, über welche sie mit der Simulationseinrichtung 28 datentechnisch in Verbindung steht. Sie kann über diese zweite Schnittstelle 48 die von der Simulationseinrichtung 28 ermittelten simulierten Zustandsdaten SZD empfangen. Die mit dem Diagnoseprogramm ausgestattete Auswerteeinheit 42 ist dazu vorgesehen, die aktuellen Zustandsdaten AZD mit den simulierten Zustandsdaten SZD zu vergleichen.

Die simulierten Zustandsdaten SZD sind für einen Sollzustand des betrachteten Teils der Anlage 16 repräsentativ. Die Diagnoseeinrichtung 38 ist dazu vorgesehen, eine Fehlermeldung zu erzeugen, wenn eine Abweichung des durch aktuelle Zustandsdaten AZD repräsentierten Istzustands des Teils der Anlage 16 vom Sollzustand durch die Auswerteeinheit 42 erkannt wird. Diese Abweichung wird durch den Vergleich der simulierten Zustandsdaten SZD mit aktuellen Zustandsdaten AZD erfasst. Die Erzeugung der Fehlermeldung kann anhand einer Schwellwertbetrachtung einer Abweichung zwischen dem von aktuellen Zustandsdaten AZD dargestellten Istzustand des Teils der Anlage 16 und dem Sollzustand erfolgen.

Ein weiterer Satz von Strukturdaten SD2, die sich von den in der Simulationseinrichtung 28 genutzten Simulationsdaten SD1 unterscheiden können, kann von der Diagnoseeinrichtung 38 herangezogen werden. Dabei handelt es sich um zusätzliche Informationen, die insbesondere Auskunft über die Lage von Bauteilen der Anlage 16 relativ zueinander und relativ zu einer bestimmten Spannungsquelle geben. Diese Informationen sind insbesondere "Strukturinformationen" genannt. Sie werden aus den Stromlaufplandaten SLD bereitgestellt, sodass die Strukturdaten SD2 und die Simulationsdaten SD1 auf der Basis eines gemeinsamen Datensatzes bereitgestellt sind.

Es werden auf der Grundlage der Strukturdaten SD2 z.B. für einen bestimmten Messpunkt der Anlage 16 verschiedene Attribute berechnet, wie z.B. die Art und Lage der einspeisenden Spannungsquelle, eine Reihenfolge von Bauteilen in einer Reihenschaltung, ein Stromverlauf bei einer parallelen Schaltung, eine Zusammengehörigkeit von Bauteilen vor dem betrachteten Messpunkt.

Das von der Auswerteeinheit 42 ausgeführte Diagnoseprogramm führt eine Auswertung der simulierten Zustandsdaten SZD, der aktuellen Zustandsdaten AZD und der Strukturdaten SD2 gemäß folgenden Regeln durch:
- Eine Abweichung zwischen aktuellem (Ist) und simulierten (Soll) Zustand des betrachteten Teils der Anlage 16 ergibt einen Fehler;
- Ein Fehler, der näher an der relevanten Spannungsquelle auftritt, unterdrückt die Erzeugung einer Fehlermeldung für einen oder mehrere hinter ihm auftretende Fehler;
- Ein Fehler, der vor einem Knoten auftritt, unterdrückt die Erzeugung einer Fehlermeldung für einen oder mehrere Fehler, die in nachgelagerten Reihenschaltungen und/oder unterlagerten Knoten auftreten.

Ein gemäß den Regeln nicht unterdrückte Fehlermeldung FM kann z.B. in der Form einer Werkstattmeldung oder einer betrieblichen Meldung BM zur Anzeige an den Fahrzeugführer zur Verfügung gestellt werden.

In einer Konfiguration mit mehreren, miteinander gekoppelten Transporteinheiten erfolgen die oben beschriebenen Erzeugung simulierter Zustandsdaten und Auswertung dieser auf der Basis von aktuellen Zustandsdaten für die jeweilige Anlage 16 der verschiedenen Transporteinheiten. Dabei kann die Steuereinheit einer bestimmen Transporteinheit des Verbands von Transporteinheiten - in der Figur die Steuereinheit 20 - die Ergebnisdaten der jeweiligen Auswertung der weiteren Transporteinheit bzw. Transporteinheiten empfangen. Dies ist in der Figur mittels eines gestrichelten Pfeils dargestellt und erfolgt über das Zugnetzwerk 14. Aus den Ergebnisdaten der gesamten Transporteinheiten werden auf den gesamten Verband von Transporteinheiten bezogene Diagnosedatensätze erzeugt. Diese Diagnosedatensätze können z.B. als betriebliche Meldungen BM über eine Anzeigeeinheit 50 einem Personal, z.B. Fahrer und/oder Begleiter des Verbands angezeigt werden. Typischerweise ist die Anzeigeeinheit 50 in einem Führerraum angeordnet (siehe Figur 1).

Es wird nun ein konkretes Beispiel anhand der Figur 3 erläutert. Diese zeigt einen Teil der Anlage 16 des Schienenfahrzeugs 10 gemäß dem aktuellen Zustand ("real", obere Darstellung) und einem auf der Basis ermittelter simulierter Zustandsdaten SZD simulierten Zustand ("simu", untere Darstellung). Der betrachtete Messpunkt entspricht einem durch ein Stromsignal betätigbaren Schütz K1. Dieses Signal geht aus von einer Spannungsquelle V und kann über einen Leistungsschutzschalter LSS1 und einen Kontakt K2 zum Schütz K1 geführt werden. Bei geschlossenem Schutzschalter LSS1 kann das Schütz K1 durch eine Betätigung des Kontakts K2 ein- und ausgeschaltet werden.

Das Schütz K1 wird durch einen Hilfskontakt E33 überwacht. Dieser kann als Sensoreinheit 22 im Sinne der allgemeinen Beschreibung oben betrachtet werden. Die Stellung des Hilfskontaktes E33 wird durch eine als I/O-Modul ausgebildete Schnittstelleneinheit 24 eingelesen.

Fällt das Schütz K1 aus, so meldet der Hilfskontakt E33 durch dessen Stellung einen Fehler. Das von der Schnittstelleneinheit 24 eingelesene Signal "real_E33" entspricht z.B. dem Wert "0". In der Simulation wird das Schütz K1 angesteuert und der Hilfskontakt E33 schließt. Dies erfolgt auf der Basis von Simulationsdaten, die im Simulationsprogramm enthalten sind, und aktuellen Zustandsdaten, insbesondere über die aktive Spannungsquelle V und den geschlossenen Leistungsschutzschalter LSS1.

Das von der Sensoreinheit 22 eingelesene Signal "simu_E33" als simulierte Zustandsdaten in der virtuellen Abbildung der Anlage 16 entspricht dem Wert "1".

Die Auswerteinheit 42 vergleicht beide Zustände, insbesondere das Signal "real_E33" als aktuelle Zustandsdaten und das Signal "simu_E33" als simulierte Zustandsdaten und meldet zum Signal "real_E33" einen Fehler.

Es wird nun davon ausgegangen, dass ein Leistungsschutzschalter LSS2, welcher den Hilfskontakt E33 mit Spannung versorgt, öffnet und die Spannungsversorgung unterbricht. Ein Hilfskontakt E32, der den Leistungsschutzschalter überwacht, ergibt ein entsprechendes Signal "real _E32" der Schnittstelleneinheit 24, das dem Wert "0" aufweist.

In der simulierten Anlage verbleibt der Leistungsschutzschalter LSS2 in der geschlossenen Stellung, sodass das Signal "simu-E32" den Wert "1" annimmt. Die Auswerteinheit 42 vergleicht beide Zustände und meldet zum Signal "real_E32" einen Fehler.

Wird in dieser Fehlstellung des Leistungsschutzschalters LSS2 das Schütz K1 eingeschaltet, kann der Hilfskontakt E33 mangels elektrischer Versorgung kein Signal abgeben, sodass das Signal "real_E33" den Wert "0" aufweist. In der simulierten Anlage meldet der Hilfskontakt E33 bei Schließung des Schützes K1 das Signal "simu_E33" mit Wert "1". Dies könnte auch zur Meldung eines Fehlers durch die Auswerteeinheit 42 führen. Gemäß den oben beschriebenen Regeln wird eine Fehlermeldung betreffend das Signal "real_E33" durch den Fehler zum Signal "real_E32" unterdrückt, da es einen Bauteil (Hilfskontakt E32) betrifft, das näher an der Spannungsquelle V angeordnet ist.

Der Leistungsschutzschalter LSS1 wird selbst durch einen Hilfskontakt E31 überwacht. Erfolgt eine fehlerhafte Öffnung des Leistungsschutzschalters LSS1, kann dies durch die Auswerteeinheit 42 durch einen Vergleich der entsprechenden Signale "real_E31" und "simu_E31" als Fehler gemeldet werden. Die Leistungsschutzschalter LSS1 und LLS2 gehören zu parallelen Schaltungszweigen, die aus einer gemeinsamen Spannungsquelle V gespeist werden. Gemäß den oben beschriebenen Regeln erfolgt keine Unterdrückung einer Fehlermeldung zum Leistungsschutzschalter LSS2 (über den Hilfskontakt E32) durch den Fehler zum Leistungsschutzschalter LSS1, da diese zu unterschiedlichen parallelen Zweigen gehören.

Ein Fehler betreffend ein Trennschütz, über welches beide Zweige LSS1 und LSS2 von der Spannungsquelle V gespeist werden - d.h. das vor einem Abzweigungsknoten der Zweige LSS1 und LSS2 angeordnet ist, würde jedoch die Fehlermeldungen zum Leistungsschutzschalter LSS1, zum Schütz K1 und zum Leistungsschutzschalter LSS2 sowie grundsätzlich zu allen Fehlern in beiden Zweigen LSS1 und LSS2 unterdrücken.

Die hier beschriebenen Regeln werden auf der Basis der Strukturdaten SD2 angewendet, welche Informationen über die relative Anordnung der oben beschriebenen Komponenten zueinander und zur Spannungsanordnung V enthalten.

## Patentansprüche

1. Transporteinheit mit zumindest einer Anlage (16), aufweisend:
eine Simulationseinrichtung (28) mit einer Schnittstelle (30), über welche aktuelle Zustandsdaten (AZD) der Anlage (16) empfangbar sind, und einer Recheneinheit (32), die dazu vorgesehen ist, auf der Basis von Simulationsdaten (SD1) und
der aktuellen Zustandsdaten (AZD) simulierte Zustandsdaten (SZD) zu ermitteln, die für einen Zustand wenigstens eines Teils der Anlage (16) repräsentativ sind,
wobei die Simulationseinrichtung (28) eine Speichereinheit (36) aufweist, in welcher zumindest ein von der Recheneinheit (32) ausführbares Simulationsprogramm gespeichert ist, wobei die Simulationsdaten (SD1) als Bestandteil des Simulationsprogramms bereitgestellt sind.

2. Transporteinheit nach Anspruch 1,
**gekennzeichnet durch**
Sensoreinheiten (22, 22'), die jeweils zur Erfassung zumindest einer Zustandskenngröße (ZK) der Anlage (16) vorgesehen sind, wobei die aktuellen Zustandsdaten auf der Basis der Zustandskenngrößen bereitgestellt werden.

3. Transporteinheit nach Anspruch 1 oder 2,
**dadurch gekennzeichnet, dass**
die Simulationsdaten (SD1) auf der zumindest teilautomatisierten Umwandlung von Stromlaufplandaten (SLD) der Anlage (16) basieren.

4. Transporteinheit nach einem der vorhergehenden Ansprüche,
**gekennzeichnet durch**
eine Dateneinrichtung (26), die dazu vorgesehen ist, die aktuellen Zustandsdaten (AZD) zur Verfügung zu stellen, und mit welcher die Simulationseinrichtung (28) über die Schnittstelle (30) datentechnisch verbindbar ist.

5. Transporteinheit nach Anspruch 4,
**gekennzeichnet durch**
eine Steuereinheit (20) zum Steuern der Anlage (16), wobei die Dateneinrichtung (26) zumindest teilweise Bestandteil der Steuereinheit (20) ist.

6. Transporteinheit nach einem der vorhergehenden Ansprüche,
**gekennzeichnet durch**
eine Diagnoseeinrichtung (38) mit einer ersten Schnittstelle (40), über welche aktuelle Zustandsdaten (AZD) der Anlage (16) empfangbar sind, einer zweiten Schnittstelle (48), über welche die simulierten Zustandsdaten (SZD) empfangbar sind, und einer Auswerteeinheit (42), die dazu vorgesehen ist, die aktuellen Zustandsdaten (AZD) mit den simulierten Zustandsdaten (SZD) zu vergleichen.

7. Transporteinheit nach Anspruch 6
**dadurch gekennzeichnet, dass**
die simulierten Zustandsdaten (SZD) für einen Sollzustand des Teils der Anlage (16) repräsentativ sind und die Diagnoseeinrichtung (38) dazu vorgesehen ist, eine Fehlermeldung (FM) zu erzeugen, wenn eine Abweichung vom Sollzustand durch die Auswerteeinheit (42) erkannt wird.

8. Transporteinheit nach Anspruch 7,
**dadurch gekennzeichnet, dass**
die Diagnoseeinrichtung (38) dazu vorgesehen ist, zur Erzeugung einer Fehlermeldung (FM) bezüglich einer ersten Einheit der Anlage Strukturdaten (SD2) zu berücksichtigen, welche für topologische und/oder funktionelle Zusammenhänge der Einheit mit zumindest einer zweiten Einheit der Anlage (16) repräsentativ sind.

9. Transporteinheit nach Anspruch 8,
**dadurch gekennzeichnet, dass**
die Diagnoseeinrichtung (38) dazu vorgesehen ist, beim Erkennen eines Satzes von Fehlern eine Fehlermeldung (FM) zumindest einem ersten Fehler zuzuordnen und anhand der Strukturdaten (SD2) die Erzeugung von Meldungen zu Fehlern zu unterdrücken, die ein Kausalitätsverhältnis zum ersten Fehler aufweisen.

10. Transporteinheit nach Anspruch 8 oder 9,
**dadurch gekennzeichnet, dass**
die Strukturdaten (SD2) und die Simulationsdaten (SD1) auf der Basis zumindest eines gemeinsamen Datensatzes bereitgestellt sind.

11. Transporteinheit nach Anspruch 4 oder 5 und nach einem der Ansprüche 6 bis 10,
**dadurch gekennzeichnet, dass**
die Diagnoseeinrichtung (38) über die erste Schnittstelle (40) mit der Dateneinrichtung (26) datentechnisch verbindbar ist.

12. Transporteinheit nach einem der vorhergehenden Ansprüche,
**gekennzeichnet durch**
die Ausbildung als Transportmittel für den öffentlichen Transport von Passagieren.

13. Transporteinheit nach einem der vorhergehenden Ansprüche,
**gekennzeichnet durch**
die Ausbildung als Schienenfahrzeug (10).

14. Verfahren zum Steuern einer Anlage (16) bei einer Transporteinheit, insbesondere einem Schienenfahrzeug (10), wobei während eines Betriebs der Transporteinheit
- aktuelle Zustandsdaten (AZD) der Anlage (16) bereitgestellt werden,
- die aktuellen Zustandsdaten (AZD) von einer Simulationseinrichtung (28) der Transporteinheit empfangen werden und
- die Simulationseinrichtung (28) auf der Basis der aktuellen Zustandsdaten (AZD) und von Simulationsdaten (SD1) simulierte Zustandsdaten (SZD) ermittelt, die für einen Zustand wenigstens eines Teils der Anlage (16) repräsentativ sind, wobei die Simulationseinrichtung (28) eine Speichereinheit (36) aufweist, in welcher zumindest ein von der Recheneinheit (32) ausführbares Simulationsprogramm gespeichert ist, wobei die Simulationsdaten (SD1) als Bestandteil des Simulationsprogramms bereitgestellt sind.

## Claims

1. Transportation unit having at least one installation (16), having:
a simulation system (28) having an interface (30), via which current status data (AZD) relating to the installation (16) can be received, and a computing unit (32), which is designed to acquire simulated status data (SZD) that is representative of a status of at least one part of the installation (16), on the basis of simulation data (SD1) and the current status data (AZD),
wherein the simulation system (28) comprises a memory unit (36), in which at least one simulation program that can be executed by the computing unit (32) is stored, wherein the simulation data (SD1) is provided as a component of the simulation program.

2. Transportation unit according to claim 1,
**characterised by**
sensor units (22, 22'), which are designed in each case to acquire at least one status parameter (ZK) relating to the installation (16), wherein the current status data is provided on the basis of the status parameters.

3. Transportation unit according to claim 1 or 2,
**characterised in that**
the simulation data (SD1) is based on the at least partly automated conversion of wiring diagram data (SLD) relating to the installation (16).

4. Transportation unit according to one of the preceding claims,
**characterised by**
a data system (26), which is designed to make available the current status data (AZD), and with which the simulation system (28) can have a data connection via the interface (30).

5. Transportation unit according to claim 4,
**characterised by**
a control unit (20) to control the installation (16), wherein the data system (26) is at least partly a component of the control unit (20).

6. Transportation unit according to one of the preceding claims,
**characterised by**
a diagnostic system (38) with a first interface (40), via which current status data (AZD) relating to the installation (16) can be received, a second interface (48), via which the simulated status data (SZD) can be received, and an evaluation unit (42), which is designed to compare the current status data (AZD) with the simulated status data (SZD).

7. Transportation unit according to claim 6
**characterised in that**
the simulated status data (SZD) is representative of a desired status of the part of the installation (16) and the diagnostic system (38) is designed to generate an error message (FM) when a deviation from the desired status is detected by the evaluation unit (42).

8. Transportation unit according to claim 7,
**characterised in that**
the diagnostic system (38) is designed, in order to generate an error message (FM) with respect to a first unit in the installation, to take into account structural data (SD2) that is representative of topological and/or functional interrelationships of the unit with at least one second unit in the installation (16).

9. Transportation unit according to claim 8,
**characterised in that**
the diagnostic system (38) is designed, when a set of errors is detected, to assign an error message (FM) to at least one first error and, on the basis of the structural data (SD2), to suppress the generation of reports regarding errors that have a causal link with the first error.

10. Transportation unit according to claim 8 or 9,
**characterised in that**
the structural data (SD2) and the simulation data (SD1) are provided on the basis of at least one common dataset.

11. Transportation unit according to claim 4 or 5 and according to one of claims 6 to 10,
**characterised in that**
the diagnostic system (38) can have a data connection with the data system (26) via the first interface (40).

12. Transportation unit according to one of the preceding claims,
**characterised by**
the unit being embodied as a means of transport for the public transportation of passengers.

13. Transportation unit according to one of the preceding claims,
**characterised by**
the unit being embodied as a rail vehicle (10).

14. Method for controlling an installation (16) in a transportation unit, in particular a rail vehicle (10), wherein, during operation of the transportation unit
- current status data (AZD) relating to the installation (16) is provided,
- the current status data (AZD) is received by a simulation system (28) in the transportation unit and
- the simulation system (28) acquires simulated status data (SZD) that is representative of a status of at least a part of the installation (16), on the basis of the current status data (AZD) and of simulation data (SD1), wherein the simulation system (28) comprises a memory unit (36), in which at least one simulation program that can be executed by the computing unit (32) is stored, wherein the simulation data (SD1) is provided as a component of the simulation program.

## Revendications

1. Unité de transport ayant au moins une installation (16), comportant :
un dispositif (28) de simulation ayant une interface (30), par laquelle des données (AZD) d'état en cours de l'installation (16) peuvent être reçues et une unité (32) informatique, qui est prévue pour déterminer, sur la base de données (SD1) de simulation et des données (AZD) d'état en cours, des données (SZD) d'état simulées,
qui sont représentatives d'un état d'au moins une partie de l'installation (16),
dans laquelle le dispositif (28) de simulation a une unité (36) de mémoire, dans laquelle au moins un programme de simulation pouvant être réalisé par l'unité (32) informatique est mis en mémoire, dans laquelle les données (SD1) de simulation sont mises à disposition en tant que partie constitutive du programme de simulation.

2. Unité de transport suivant la revendication 1,
**caractérisée**
**par** des unités (22, 22') de capteur, qui sont prévues chacune pour la détection d'au moins une grandeur (ZK) caractéristique d'état de l'installation (16), des données d'état en cours étant mises à disposition sur la base des grandeurs caractéristiques d'état.

3. Unité de transport suivant la revendication 1 ou 2,
**caractérisée**
**en ce que** les données (SD1) de simulation reposent sur la transformation automatisée au moins en partie de données (SLD) de schéma de circuit de l'installation (16).

4. Unité de transport suivant l'une des revendications précédentes,
**caractérisée**
**par** un dispositif (26) de données, qui est prévu pour mettre à disposition les données (AZD) d'état en cours, et par lequel le dispositif (28) de simulation peut être relié en technique de données par l'intermédiaire de l'interface (30).

5. Unité de transport suivant la revendication 4,
**caractérisée**
**par** une unité (20) de commande pour la commande de l'installation (16), le dispositif (26) de données étant une partie constitutive au moins en partie de l'unité (20) de commande.

6. Unité de transport suivant l'une des revendications précédentes,
**caractérisée par**
un dispositif (38) de diagnostic ayant une première interface (40), par laquelle des données (AZD) d'état en cours de l'installation (16) peuvent être reçues, une deuxième interface (48), par laquelle les données (SZD) d'état simulées peuvent être reçues et une unité (42) d'analyse, qui est prévue pour comparer les données (AZD) d'état en cours aux données (SZD) d'état simulées.

7. Unité de transport suivant la revendication 6,
**caractérisée en ce que**
les données (SZD) d'état simulées sont représentatives d'un état de consigne de la partie de l'installation (16) et le dispositif (38) de diagnostic est prévu pour produire un message (FM) de défaut, si un écart à l'état de consigne est détecté par l'unité (42) d'analyse.

8. Unité de transport suivant la revendication 7,
**caractérisée en ce que**
le dispositif (38) de diagnostic est prévu pour tenir compte, pour la production d'un message (FM) de défaut en ce qui concerne une première unité de l'installation, de données (SD2) de structure, qui sont représentatives de relations topologiques et/ou fonctionnelles de l'unité avec au moins une deuxième unité de l'installation (16).

9. Unité de transport suivant la revendication 8,
**caractérisée en ce que**
le dispositif (38) de diagnostic est prévu pour, à la détection d'un ensemble de défauts, affecter un message (FM) de défaut au moins à un premier défaut et supprimer, à l'aide des données (SD2) de structure, la production de messages de défaut, qui ont un rapport de causalité avec le premier défaut.

10. Unité de transport suivant la revendication 8 ou 9,
**caractérisée en ce que**
les données (SD2) de structure et les données (SD1) de simulation sont mises à disposition sur la base d'au moins un ensemble de données commun.

11. Unité de transport suivant la revendication 4 ou 5 et suivant l'une des revendications 6 à 10,
**caractérisée en ce que**
le dispositif (38) de diagnostic peut être relié en technique de données au dispositif (26) de données par la première interface (40) .

12. Unité de transport suivant l'une des revendications précédentes,
**caractérisé par**
la constitution en moyen de transport pour le transport public de passagers.

13. Unité de transport suivant l'une des revendications précédentes,
**caractérisée par**
la constitution en véhicule (10) ferroviaire.

14. Procédé de commande d'une installation (16) dans une unité de transport, notamment d'un véhicule (10) ferroviaire, dans lequel, pendant un fonctionnement de l'unité de transport,
- on met à disposition des données (AZD) d'état en cours de l'installation (16),
- on reçoit les données (AZD) d'état en cours par un dispositif (28) de simulation de l'unité de transport et
- le dispositif (28) de simulation détermine, sur la base des données (AZD) d'état en cours et des données (SD1) de simulation, des données (SZD) d'état simulées, qui sont représentatives d'un état d'au moins une partie de l'installation (16), dans lequel le dispositif (28) de simulation a une unité (36) de mémoire, dans laquelle au moins un programme de simulation pouvant être réalisé par l'unité (32) informatique est mis en mémoire, les données (SD1) de simulation étant mises à disposition, comme partie constitutive du programme de simulation.
